(19) Europäisches Patentamt / European Patent Office / Office européen des brevets

(11) **EP 4 145 214 A1**

(12) **EUROPEAN PATENT APPLICATION**
published in accordance with Art. 153(4) EPC

(43) Date of publication:
**08.03.2023 Bulletin 2023/10**

(51) International Patent Classification (IPC):
**G02F 1/1333** (2006.01)   **G02F 1/133** (2006.01)
**G02F 1/1345** (2006.01)   **G03B 29/00** (2006.01)

(21) Application number: **21817408.4**

(22) Date of filing: **07.05.2021**

(86) International application number:
**PCT/CN2021/092084**

(87) International publication number:
**WO 2021/244214 (09.12.2021 Gazette 2021/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **01.06.2020   CN 202010485478**

(71) Applicant: **GUANGDONG OPPO MOBILE TELECOMMUNICATIONS CORP., LTD.**
**Dongguan, Guangdong 523860 (CN)**

(72) Inventor: **ZHANG, Gong**
**Dongguan, Guangdong 523860 (CN)**

(74) Representative: **Thorniley, Peter**
**Venner Shipley LLP**
**200 Aldersgate**
**London EC1A 4HD (GB)**

(54) **DISPLAY PANEL AND ELECTRONIC DEVICE**

(57)     A display panel and an electronic device are provided. The display panel includes a pixel layer. The pixel layer includes a first display region and a second display region. Multiple first pixel units are disposed in the first display region. Multiple second pixel units are disposed in the second display region. The second display region allows light from a display side of the display panel to pass through the display panel. A first light-emitting ratio of the first display region is equal to a second light-emitting ratio of the second display region, the first light-emitting ratio is a ratio of the area of first pixel units in a unit area of the first display region to the unit area of the first display region, and the second light-emitting ratio is a ratio of the area of second pixel units in a unit area of the second display region to the unit area of the second display region. For a first pixel unit and a second pixel unit a same color, the second pixel unit has the area smaller than or equal to the first pixel unit.

FIG. 1

**Description**

CROSS-REFERENCE TO RELATED APPLICATION(S)

This application claims priority to and the benefit of Chinese patent application No.202010485478.3, filed Jun. 01, 2020, and entitled "DISPLAY PANEL AND ELECTRONIC DEVICE", the entire disclosure of which is incorporated herein by reference.

TECHNICAL FIELD

The disclosure relates to electronic devices, in particular to a display panel and an electronic device.

BACKGROUND

With development and progress in technology, full screens are increasingly widely used in various kinds of terminal devices. However, for the terminal device with a front camera, installation of the front camera needs to be considered, and thus it is difficult for current mobile phones or other mobile terminal devices to realize the full screen in true sense. Therefore, how to truly realize coexistence of the full screen and the front camera is an urgent problem to be solved.

It should be noted that information disclosed in the background is only intended to enhance understanding of the background of this disclosure, and thus it can include information that does not constitute the prior art known to those ordinary skilled in the art.

SUMMARY

The present disclosure is directed to a display panel and an electronic device, so as to at least partially solve one or more problems caused by defects of related art.

According to an aspect of the present disclosure, a display panel including a pixel layer is provided. The pixel layer includes a first display region and a second display region. Multiple first pixel units are disposed in the first display region. Multiple second pixel units are disposed in the second display region. Light from a display side of the display panel can pass through the second display region to reach a back side of the display panel. A first light-emitting ratio of the first display region is equal to a second light-emitting ratio of the second display region, the first light-emitting ratio is a ratio of the area of first pixel units in a unit area of the first display region to the unit area of the first display region, and the second light-emitting ratio is a ratio of the area of second pixel units in a unit area of the second display region to the unit area of the second display region. For a first pixel unit and a second pixel unit of a same color, the second pixel unit has the area smaller than or equal to the first pixel unit.

According to another aspect of the present disclosure, an electronic device including the display panel described above is provided.

It should be understood that the above general description and following detailed description are exemplary and explanatory only, and do not limit the disclosure.

BRIEF DESCRIPTION OF THE DRAWINGS

Accompanying drawings, which are incorporated into and constitute a part of specification herein, illustrate implementations consistent with the disclosure, and together with the specification, serve to explain principles of the disclosure. Obviously, the accompanying drawings in the following description are merely some implementations of the present disclosure, and other accompanying drawings can be obtained for those ordinary skilled in the art according to these accompanying drawings without creative efforts.

FIG. 1 is a schematic diagram of a first display panel according to an exemplary implementation of the present disclosure.
FIG. 2 is a schematic diagram of a second display panel according to an exemplary implementation of the present disclosure.
FIG. 3 is a schematic diagram of a third display panel according to an exemplary implementation of the present disclosure.
FIG. 4 is a circuit diagram of a pixel driving unit according to an exemplary implementation of the present disclosure.
FIG. 5 is a schematic diagram of a fourth display panel according to an exemplary implementation of the present disclosure.
FIG. 6 is a schematic diagram of a via connection structure according to an exemplary implementation of the present disclosure.
FIG. 7 is a schematic diagram of an electronic device according to an exemplary implementation of the present disclosure.

Reference signs in the figures are as follows: 110, first display region; 101, first pixel unit; 120, second display region; 121, transition display region; 122, light-transmitting display region; 102, second pixel unit; 1221, light-transmitting region; 201, pixel driving unit; 202, transition driving unit; 203, light-transmitting driving unit; 301, via; 302, first connection trace; 20, frame; 30, main board; 40, battery; 50, back cover; and 300, camera module.

DETAILED DESCRIPTION

Exemplary implementations will now be described more comprehensively with reference to the accompanying drawings. However, the exemplary implementations can be implemented in various forms and should not be construed as limited to implementations set forth herein. On the contrary, these implementations are provided so as to make this disclosure comprehensive and complete, and fully convey concept of the exemplary implementations to those skilled in the art. Like reference signs in the accompanying drawings indicate identical or similar structures, and detailed description thereof will be omitted.

Although relative terms such as "up" and "down" are used in this specification to describe a relative relationship of one illustrated component to another component, these terms are used in this specification only for convenience, for example, according to exemplary directions illustrated in the accompanying drawings. It can be understood that if the illustrated device is turned upside down, a component described at the "top" will become a component at the "bottom". When a structure is "above" other structures, it may indicate that the structure is integrally formed on the other structures, or that the structure is "directly" disposed on the other structures, or that the structure is "indirectly" disposed on other structures through another structure.

Terms "a", "an", "the", and "said" are used to indicate existence of one or more elements/components/etc. Terms "including" and "having" are intended to cover non-exclusive inclusion and indicate that there may be other elements/components/etc. besides listed elements/components/etc. Terms "first" and "second" are only used as markers, not as limitation on numbers of corresponding objects.

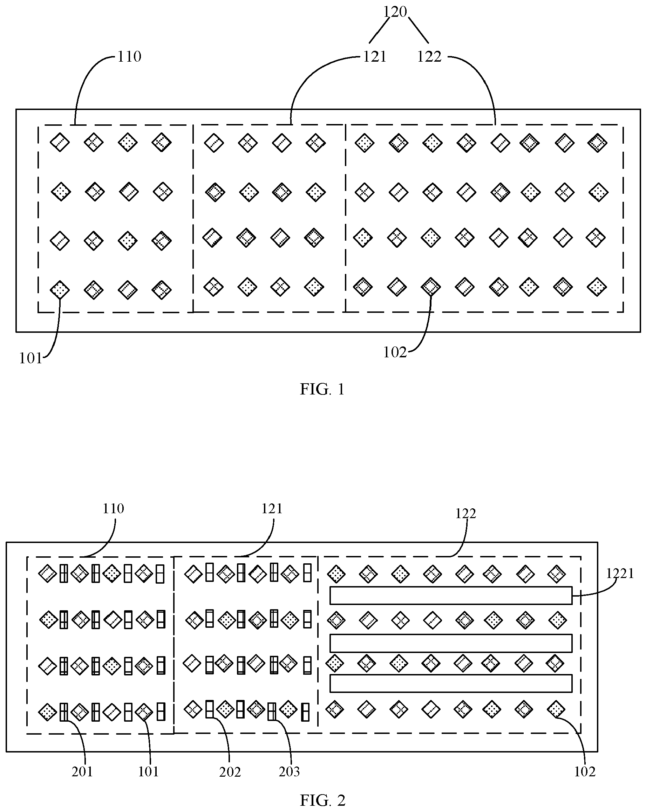

First, a display panel is provided in an exemplary implementation of the present disclosure. As illustrated in FIG. 1, the display panel includes a pixel layer. The pixel layer includes a first display region 110 and a second display region 120. Multiple first pixel units 101 are disposed in the first display region 110. Multiple second pixel units 102 are disposed in the second display region 120. A first light-emitting ratio of the first display region 110 is equal to a second light-emitting ratio of the second display region 120, the first light-emitting ratio is a ratio of the area of first pixel units 101 in a unit area of the first display region 110 to the unit area of the first display region 110, and the second light-emitting ratio is a ratio of the area of second pixel units 102 in a unit area of the second display region 120 to the unit area of the second display region 120. For a first pixel unit 101 and a second pixel unit 102 of a same color, the second pixel unit 102 has the area smaller than or equal to the first pixel unit 101. Light from a display side of the display panel can pass through the second display region 120 to reach a back side of the display panel.

The display panel provided in this implementation of the disclosure includes the first display region 110 and the second display region 120. The second display region 120 allows the light from the display side of the display panel to pass through the display panel, and then allow external light to enter a camera disposed on a back of the display panel, so as to realize light entrance at the under-screen camera. In addition, the second pixel unit 102 is disposed in the second display region 120 for display purpose, so that a region where the under-screen camera is located can display, thus realizing a true full screen. The first light-emitting ratio of the first display region 110 is equal to the second light-emitting ratio of the second display region 120, and for the first pixel unit 101 and the second pixel unit 102 of the same color, the second pixel unit 102 is smaller than or equal to the first pixel unit 101 in area, which not only takes into account the total light-emitting area of the multiple second pixel units 102 in the second display region 120 but also reduces the area of a single second pixel unit 102, so that graininess of screen displaying in the second display region 120 can be reduced, and display quality of the second display region 120 can be improved.

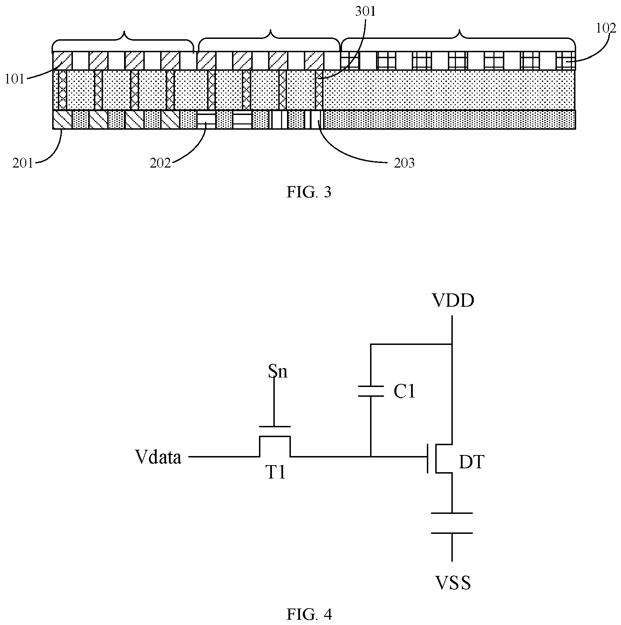

Further, the display panel provided in the implementation of the present disclosure may further include a driving circuit layer, as illustrated in FIGS. 2 and 3, the driving circuit layer includes multiple pixel driving units 201, and the pixel driving units 201 are configured to provide driving signals to drive corresponding pixel units.

Various parts of the display panel provided in the implementation of the present disclosure will be described in detail below.

The display panel provided in implementations of this disclosure may be an organic light-emitting diode (OLED) display panel or a liquid crystal display (LCD) display panel. When the display panel is an OLED display panel, the pixel layer may include a pixel electrode layer, a light-emitting layer, a common electrode layer, and a pixel definition layer. The light-emitting layer is disposed between the pixel electrode layer and the common electrode layer. The pixel electrode layer includes multiple pixel electrodes, the light-emitting layer includes multiple light-emitting units, and the pixel definition layer surrounds the light-emitting units to separate the multiple light-emitting units. The multiple light-emitting units may include multiple red light-emitting units, green light-emitting units, and blue light-emitting units.

Based on the above, the first pixel unit 101 of the first display region 110 refers to a pixel unit composed of a light-emitting unit in the first display region 110, a pixel electrode corresponding to the light-emitting unit in the first display region 110, and a common electrode corresponding to the light-emitting units in the first display region 110. For example, the first pixel unit 101 may be a red pixel unit, a green pixel unit, or a blue pixel unit in the first display region 110. The second pixel unit 102 of the second display region 120 refers to a pixel unit composed of a light-emitting unit in the second display region 120, a pixel electrode corresponding to the light-emitting unit in the second display region 120, and a common electrode corresponding to the light-emitting unit in the second display region 120. For example, the second pixel unit 102 may be a red pixel unit, a green pixel unit, or a blue pixel unit in the second display region 120.

When the display panel is an LCD display panel, the pixel layer may include a pixel electrode layer, a liquid crystal layer, a common electrode layer, a first polarizer layer, a color film layer, a black matrix layer, and a second polarizer layer. The liquid crystal layer is disposed between the pixel electrode layer and the common electrode layer. The first polarizer layer is disposed on one side of the liquid crystal layer away from the pixel electrode layer, the color film layer is disposed on one side of the first polarizer layer away from the liquid crystal layer, the black matrix layer is disposed on one side of the color film layer away from the first polarizer layer, and the second polarizer is disposed on one side of the black matrix layer away from the color film layer.

Based on the above, the first pixel unit 101 of the first display region 110 is a generic name for various pixel layers corresponding to a color unit on a color film substrate in the first display region 110. The second pixel unit 102 in the second display region 120 is a generic name for various layers of the pixel layer corresponding to a color unit on the color film substrate in the second display region 120.

The first light-emitting ratio refers to a ratio of total areas of multiple first pixel units 101 in a unit area of the first display region 110 to the unit area of the first display region 110, that is, a ratio of an opening area of the pixel definition layer in a unit area of the first display region 110 to the unit area of the first display region 110. A formula for calculating the first light-emitting ratio can be as follows.

$$f1 = \frac{\sum s1i}{s1} \times 100\%$$

f1 represents the first light-emitting ratio, s 11 represents the area of a single first pixel unit 101 in the first display region 110, and S1 represents a total area of the first display region 110.

The second light-emitting ratio refers to a ratio of total areas of multiple second pixel units 102 in a unit area of the second display region 120 to the unit area of the second display region 120, that is, a ratio of an opening area of the pixel definition layer in a unit area of the second display region 110 to the unit area of the second display region 110. A formula for calculating the second light-emitting ratio can be as follows.

$$f2 = \frac{\sum s2i}{s2} \times 100\%$$

f2 represents the second light-emitting ratio, s2i represents the area of a single second pixel unit 102 in the second display region 120, and S2 represents a total area of the second display region 120.

The first light-emitting ratio of the first display region 110 is equal to the second light-emitting ratio of the second display region 120. The first light-emitting ratio of the first display region 110 is equal to the light-emitting ratio of the second display region 120, so that brightness of the first display region 110 and the second display region 120 are consistent under a same driving signal, that is, there is no need to set a compensation driving-signal for the second display region 120, and thus driving of the display panel is unified, which can simplify a manufacturing process of the display panel and reduce complexity of a driving signal of the display panel.

For the first pixel unit and the second pixel unit of the same color, the second pixel unit 102 is smaller than or equal to the first pixel unit 101 in area. For example, the area of a second pixel unit of red 102 is smaller than or equal to that of a first pixel unit of red 101, the area of second pixel unit of green 102 is smaller than or equal to that of a first pixel unit of green 101, and the area of a second pixel unit of blue 102 is less than or equal to that of a first pixel unit of blue 101. For a first pixel unit 101 and a second pixel unit 102 of different colors, the area of the second pixel unit 102 may be larger than, equal to, or smaller than that of the first pixel unit 101.

It is noted that a correspondence between the second pixel unit 102 and the first pixel unit 101 can be distinguished by colors. In practice, pixel units of the same color may include multiple pixel units with different shapes or areas, here, the correspondence between the second pixel unit 102 and the first pixel unit 101 may be based on colors, shapes, and relative areas of the pixel units.

For example, when pixel arrangement of a display panel is a RGBG model, a pixel of the display panel includes two green pixel units. In this arrangement, when the two green pixel units have the same shapes and areas, in a correspondence between a second pixel unit of green 102 and a first pixel unit of green 101, the two green pixel units will not be distinguished. If the two light-emitting pixels of green have different shapes or areas, in the correspondence between the second pixel unit of green 102 and the first pixel unit of green 101, both light color and shape as well as the area of a corresponding pixel unit should be involved.

The first pixel unit 101 in the implementation of the present disclosure refers to a pixel unit in a normal display region of the display panel. The second pixel unit 102 refers to a pixel unit in the second display region 120 of the display panel. It should be noted that the second pixel unit 102 is not light-transmissive, and in practice, light is transmitted through a light-transmitting region around the second pixel unit 102.

For example, the second pixel unit 102 and the first pixel unit 101 of the same color have the same area. When the second pixel unit 102 and the first pixel unit 101 of the same color have the same area, visual difference between the first display region 110 and the second display region 120 can be reduced, which can improve display quality of the display panel.

Further, the second pixel unit 102 and the first pixel unit 101 of the same color have the same shape. When the second pixel unit 102 and the first pixel unit 101 of the same color have the same shape, visual difference between the first display region 110 and the second display region 120 can be further reduced, which can improve display quality of the display panel.

The second display region 120 includes multiple repeating pixel regions, and each pixel region includes two rows of second pixel units, a second pixel unit of red, a second pixel unit of green, a second pixel unit of red, a second pixel unit of green, a second pixel unit of blue, a second pixel unit of green, a second pixel unit of blue, and a second pixel unit of green are sequentially distributed in a first row of second pixel units; and a second pixel unit of green, a second pixel unit of blue, a second pixel unit of green, a second pixel unit of blue, a second pixel unit of green, a second pixel unit of red, a second pixel unit of green, and a second pixel unit of red are sequentially distributed in a second row of second pixel units. In practice, the second pixel units 102 of the second display region 120 may be disposed in other ways, and implementations of the present disclosure are not limited to this.

The pixel arrangement of the first display region 110 may be diamond subpixel rendering (SPR). Based on the above, the first display region 110 may also include multiple repeating pixel regions. One pixel region includes two rows of first pixel units 101. A second pixel unit of red, a second pixel unit of green, a second pixel unit of blue, and a second pixel unit of green are sequentially distributed in a first row of first pixel units 101. A second pixel unit of blue, a second pixel unit of green, a second pixel unit of red, and a second pixel unit of green are sequentially distributed in a second row of first pixel units 101.

The second display region 120 includes a light-transmitting display region 122 and a transition display region 121. The light-transmitting display region 122 has a light-transmitting region 1221 that allows light from the display side of the display panel to pass through the display panel. The transition display region 121 is disposed between the first display region 110 and the light-transmitting display region 122.

The first display region 110 may surround the second display region 120, or the second display region 120 may be located at one side of the first display region 110, which is not limited in implementations of the present disclosure. When the first display region 110 surrounds the second display region 120, the transition display region 121 may be an annular region. When the second display region 120 is located at one side of the first display region 110, the transition display region 121 may be a strip region, such as a rectangular strip region or a semicircular strip region.

The transition display region 121 is disposed between the first display region 110 and the light-transmitting display region 122. The transition display region 121 is only for display purpose, and at the transition display region, external light will not enter the display panel through the transition display region 121. The light-transmitting region 1221 of the light-transmitting display region 122 and the second pixel units 102 are staggered, and external light can reach the back side of the display panel through the light-transmitting region 1221. The back side of the display panel refers to a side of the display panel away from the display side.

When the display panel is an OLED display panel, a through-hole is defined in the pixel definition layer at a position corresponding to the light-transmitting region 1221, and the through-hole can be filled with a transparent medium. External lights can enter the under-screen camera through the through-hole on the pixel definition layer.

When the display panel is an LCD display panel, the first polarizer layer, the second polarizer layer, the black matrix layer defines light-transmitting through-holes at positions corresponding to the light-transmitting region 1221. The through-holes at respective layers can be filled with transparent materials, such as optical adhesive. External lights can enter the under-screen camera through the through-holes. Liquid crystal corresponding to the light-transmitting through-holes can be deflected to be in a light-transmitting state when the under-screen camera is shooting.

The driving circuit layer includes multiple pixel driving units 201. Light-transmitting driving units 203 are disposed in a projection region of the transition display region 121 on the driving circuit layer, and the light-transmitting driving units 203 are pixel driving units 201 connected with second pixel units 102 in the light-transmitting display region 122.

By arranging the light-transmitting driving unit 203 in the transition display region 121, the number of transistors and traces at positions of the driving circuit layer corresponding to the light-transmitting display region 122 can be reduced, which facilitates light transmitting of the projection region of the light-transmitting display region 122 on the driving circuit layer.

The pixel driving unit 201 in the implementation of this disclosure may include a pixel driving circuit. For example, as illustrated in FIG. 4, the pixel driving circuit may include a first transistor T1, a driving transistor DT, and a storage capacitor C1. A first end of the first transistor T1 is connected with a data signal Vdata, a second end of the first transistor T1 is connected with a control end of the driving transistor DT, and a control end of the first transistor T1 is connected with a scanning signal Sn. A first end of the driving transistor DT is connected with a first power signal VDD, and a second end of the driving transistor DT is connected with a pixel electrode. A first end of the storage capacitor C1 is connected with the first power signal VDD, a second end of the storage capacitor C1 is connected with the control end of the driving transistor DT, and a common electrode is connected with a second power signal VSS. The first transistor T1 is turned on in response to the scan signal Sn so as to transmit the data signal Vdata to the control end of the driving transistor DT, and to write the data signal Vdata into the storage capacitor C1. The driving transistor DT is turned on in response to the data signal Vdata in the storage capacitor C1 so as to transmit the first power signal VDD to the pixel electrode. In practice, the pixel driving circuit can also be other pixel driving circuits, such as a 5T1C pixel driving circuit or a 7T1C pixel circuit, etc., which is not limited in implementations of the present disclosure.

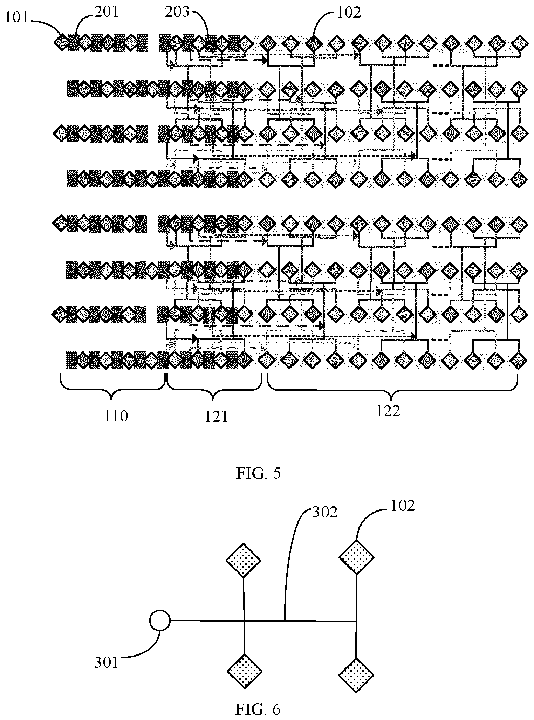

The light-transmitting driving unit 203 and the transition driving unit 202 are disposed in a projection region of the transition display region 121 on the driving circuit layer. As illustrated in FIG. 5, one light-transmitting driving unit 203 can be electrically connected with more than one second pixel unit 102. For example, two, three, four, or five second pixel units 102 are connected with one light-transmitting driving unit 203. By electrically connecting the more than one second pixel unit 102 with one light-transmitting driving unit 203, space of the driving circuit layer can be saved. One light-transmitting driving units 203 can be electrically connected with more than one second pixel unit 102 of the same color. By connecting the more than one second pixel unit 102 of the same color with the same light-transmitting driving unit 203, the space of the driving circuit layer can be saved, and control can be facilitated. It can be understood that the more than one second pixel unit 102 connected with one light-transmitting driving unit 203 can also be second pixel units 102 of different colors, which is not limited in implementations of the present disclosure.

The pixel layer includes multiple pixel electrodes. Pixel electrodes of the more than one second pixel unit 102 connected with one light-transmitting driving unit 203 are connected with one another through a first connection trace, and any of the pixel electrodes of the more than one second pixel unit 102 connected with one light-transmitting driving unit 203 is connected with the light-transmitting driving unit 203 through the via 301. The first connection trace is disposed in the pixel layer.

For example, as illustrated in FIG. 6, one light-transmitting driving unit 203 can be connected with four second pixel units 102, the four second pixel units 102 are connected with the light-transmitting driving unit 203 through the via 301 so as to transmit the driving signal from the driving circuit layer to the pixel electrode layer. Pixel electrodes of the four second pixel units 102 are sequentially connected through the first connection trace 302, or respectively connected through the first connection trace 302. The via 301 can be in the transition display region 121 and connected with the first connection trace 302 through a wire.

Connection between the light-transmitting driving unit 203 and the more than one second pixel unit 102 is realized by one via 301, which can reduce the number of via 301, reduce manufacturing complexity, and save cost of the display panel.

It can be understood that in implementations of the present disclosure, the pixel electrode layer includes multiple pixel electrodes, and a pixel electrode of each of the second pixel units 102 is connected with the light-transmitting driving unit 203 through a via 301.

Transition driving units 202 are disposed in the projection region of the transition display region 121 on the driving circuit layer, the transition driving units 202 are pixel driving units 201 connected with second pixel units 102 in the transition display region 121 among the multiple pixel driving units.

One transition driving unit 202 can be connected with more than one second pixel unit 102, for example, two, three, four, or five second pixel units 102 can be connected with one transition driving unit 202. Space of the driving circuit layer can be saved by electrically connecting the more than one second pixel unit 102 with one transition driving unit 202. One transition driving units 202 can be electrically connected with more than one second pixel unit 102 of the same color. By connecting the more than one second pixel unit 102 of the same color with the same transition driving unit 202, the space of the driving circuit layer can be saved, and control can be facilitated. It can be understood that the more than one second pixel unit 102 connected with one transition driving unit 202 can also be second pixel units 102 of different colors, which is not limited in the implementation of the present disclosure.

The pixel layer includes multiple pixel electrodes. Pixel electrodes of the more than one second pixel unit 102 connected with one transition driving unit 202 are connected with one another through the first connection trace, and any pixel electrode of the more than one second pixel unit 102 connected with one transition driving unit 202 is connected with the transition driving unit 202 through the via 301. The first connection trace is disposed in the pixel layer.

For example, one transition driving unit 202 can be connected with four second pixel units 102. One of the four second pixel units 102 is connected with the transition driving unit 202 through the via 301 so as to transmit the driving signal from the driving circuit layer to the pixel electrode layer. Pixel electrodes of the other three second pixel units 102 of the four second pixel units 102 are connected with a pixel electrode of the second pixel unit 102 connected with the via 301. The pixel electrodes of the other three second pixel units 102 of the four second pixel units 102 can be sequentially connected through a second connection trace to be connected with the pixel electrode of the second pixel unit 102 connected with the via 301, or the pixel electrodes of the other three second pixel units 102 of the four second pixel units 102 can be connected with the pixel electrode of the second pixel unit 102 connected with the via 301 respectively through the first connection trace 302.

It should be noted that in the practical applications, the second pixel unit 102 in the light-transmitting display region 122 and the second pixel unit 102 in the transition display region 121 can share the light-transmitting driving unit 203 or the transition driving unit 202, which is not limited in the implementation of this disclosure.

When the display panel is an OLED display panel, the pixel definition layer in the pixel layer is disposed on the common electrode, the pixel definition layer defines a light-transmitting opening in a region of the second display region 120, and the light-transmitting opening and the second pixel unit 102 are staggered. The first connection trace 302 connecting more than one pixel electrode needs to avoid the light-transmitting opening, that is, a projection of the first connection trace 302 on the pixel definition layer does not overlap the light-transmitting opening.

When the display panel is an LCD display panel, the black matrix layer in the pixel layer is disposed on the color film substrate, the black matrix layer defines a light-transmitting opening in a region of the second display region 120, and the light-transmitting opening and the second pixel unit 102 are staggered. The second connection trace connecting the more than one pixel electrode needs to avoid the light-transmitting opening, that is, a projection of the first connection trace 302 on the black matrix layer does not overlap the light-transmitting opening.

The display panel provided in implementations of the disclosure includes the first display region 110 and the second display region 120. The second display region 120 can allow the light from the display side of the display panel to pass through the display panel, and then allow external light to enter a camera arranged on a back of the display panel, so as to realize light entrance at the under-screen camera. In addition, the second pixel unit 102 is disposed in the second display region 120 for display purpose, so that a region where the under-screen camera is located can display, thus realizing a true full screen. For the first pixel unit 101 and the second pixel unit 102 of the same color, the second pixel unit 102 is smaller than or equal to the first pixel unit 101 in area. Light from a display side of the display panel can pass through the second display region 120 to reach a back side of the display panel.

An electronic device is further provided in implementations of this disclosure, which includes the display panel described above.

The electronic device provided in this implementation of the disclosure includes the display panel described above. The display panel includes the first display region 110 and the second display region 120. The second display region 120 can allow the light from the display side of the display panel to pass through the display panel, and then allow external light to enter a camera disposed on a back of the display panel, so as to realize light entrance at the under-screen camera. In addition, the second pixel unit is disposed in the second display region 120 for display purpose, so that a region where the under-screen camera of the electronic device is located can display, thus realizing a true full-screen electronic device.

Further, the electronic device further includes a camera module disposed on the back of the display panel, a projection region of the camera module on the display panel is in the second display region 120.

The electronic device provided in implementations of this disclosure can be a mobile phone, a tablet computer, a notebook computer, an electronic reader, a vehicle-mounted computer, or the like. In the following, the electronic device will be illustrated in detail by taking a mobile phone as an example.

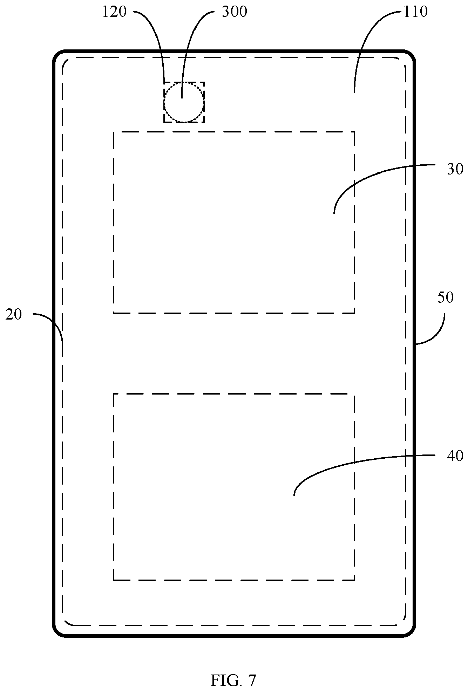

As illustrated in FIG. 7, the electronic device further includes a frame 20, a main board 30, a battery 40, and a back cover 50. The display panel is installed on the frame 20 to form a display surface of the electronic device, and the display panel serves as a front case of the electronic device. The back cover 50 is attached to the frame through a double-sided adhesive tape, and the display panel, the frame 20, and the back cover 50 cooperatively define an accommodating space for accommodating other electronic components or functional modules of the electronic device. Meanwhile, the display panel forms the display surface of the electronic device for displaying information such as images and texts. The display panel can be an LCD.

The display panel can be a full screen. The display panel can display information in the full screen, so that the electronic device has a large screen-to-body ratio. The display panel may include the first display region 110 and the second display region 120. The screen is required to be light-transmissive during usage of the under-screen camera, and thus with the second display region 120 with a low pixel density having a light-transmitting region, light transmittance can be increased. The camera module of the electronic device can be disposed under the second display region 120, that is, at a side of the second display region 120 away from a light-emitting side. The first display region 110 with high transmittance can increase intensity of light received by the camera module 300. The camera module 300 can be a front camera. A functional module such as a proximity sensor can be hidden under the display panel, while a fingerprint identification module of the electronic device can be disposed on a back of the electronic device.

The frame 20 can be of a hollow frame structure. The frame 20 can be made of metal or plastic. The main board 30 is installed in the accommodating space. For example, the main board 30 can be mounted on the frame 20, and accommodated in the accommodating space together with the frame 20. The main board 30 is provided with a ground point to realize grounding of the main board 30. The main board 30 can be integrated with one or more of functional modules such as a motor, a microphone, a speaker, a receiver, an earphone interface, a universal serial bus (USB) interface, a camera, a proximity sensor, an ambient light sensor, a gyroscope, and a processor. Meanwhile, the display panel may be electrically connected with the main board 30.

The main board 30 is provided with a display control circuit. The display control circuit outputs an electrical signal to the display panel to control the display panel to display information. The battery 40 is installed in the accommodating space. For example, the battery 40 can be mounted on the frame 20 and accommodated in the accommodating space together with the frame 20. The battery 40 can be electrically connected with the main board 30, so that the battery 40 can power the electronic device. The main board 30 may be provided with a power management circuit. The power management circuit is configured to distribute a voltage provided by the battery 40 to various electronic components of the electronic device.

The back cover 50 forms an outer contour of the electronic device. The back cover 50 may be integrally formed. During a molding process of the back cover 50, structures such as a rear-camera hole and a fingerprint-identification-module-mounting hole can be defined at the back cover 50.

Other implementations of the present disclosure will readily occur to those skilled in the art with considering the specification and practicing the disclosure provided herein. This disclosure is intended to cover any variations, uses, or adaptations of this disclosure, which follow general principles of this disclosure and include common knowledge or customary practice in the art not provided in this disclosure. The specification and implementations are regarded to be exemplary only, and a true scope and spirit of the present disclosure are indicated by appended claims.

**Claims**

1. A display panel, comprising a pixel layer, wherein the pixel layer comprises:

   a first display region, a plurality of first pixel units being disposed in the first display region; and
   a second display region, a plurality of second pixel units being disposed in the second display region, wherein
   a first light-emitting ratio of the first display region is equal to a second light-emitting ratio of the second display region, the first light-emitting ratio being a ratio of an area of first pixel units in a unit area of the first display region to the unit area of the first display region, and the second light-emitting ratio being a ratio of an area of second pixel units in a unit area of the second display region to the unit area of the second display region; for a first pixel unit and a second pixel unit of a same color, the second pixel unit has an area smaller than or equal to the first pixel unit; and light from a display side of the display panel can pass through the second display region to reach a back side of the display panel.

2. The display panel of claim 1, wherein for the first pixel unit and the second pixel unit which of a same color, the second pixel units has an area smaller than the first pixel unit.

3. The display panel of claim 1, wherein the second display region comprises:

   a light-transmitting display region having a light-transmitting region that allows light from the display side of the display panel to pass through the display panel; and
   a transition display region between the first display region and the light-transmitting display region, wherein
   the display panel further comprises:
   a driving circuit layer comprising a plurality of pixel driving units, light-transmitting driving units being disposed in a projection region of the transition display region on the driving circuit layer, and the light-transmitting driving units are pixel driving units connected with second pixel units in the light-transmitting display region.

4. The display panel of claim 3, wherein one light-transmitting driving unit is electrically connected with more than one second pixel unit.

5. The display panel of claim 4, wherein the pixel layer comprises a plurality of pixel electrodes, pixel electrodes of the more than one second pixel unit connected with the one light-transmitting driving unit are connected with one another through a first connection trace, and the pixel electrodes of the more than one second pixel unit are connected with the one light-transmitting driving unit through a via, the first connection trace being disposed in the pixel layer.

6. The display panel of claim 4, wherein the pixel layer comprises a plurality of pixel electrodes, and a pixel electrode of each of the more than one second pixel unit is connected with the light-transmitting driving unit through a via.

7. The display panel of claim 3, wherein transition driving units are disposed in the projection region of the transition display region on the driving circuit layer, the transition driving units being pixel driving units, among the plurality of pixel driving units, connected with second pixel units in the transition display region.

8. The display panel of claim 7, wherein one transition driving unit is connected with more than one second pixel unit.

9. The display panel of claim 8, wherein one transition driving unit is connected with four second pixel units.

10. The display panel of claim 1, wherein the second display region comprises a plurality of repeating pixel regions, and each pixel region comprises two rows of second pixel units, wherein a second pixel unit of red, a second pixel unit of green, a second pixel unit of red, a second pixel unit of green, a second pixel unit of blue, a second pixel unit of green, a second pixel unit of blue, and a second pixel unit of green are sequentially distributed in a first row of second pixel units; and a second pixel unit of green, a second pixel unit of blue, a second pixel unit of green, a second pixel unit of blue, a second pixel unit of green, a second pixel unit of red, a second pixel unit of green, and a second pixel unit of red are sequentially distributed in a second row of second pixel units.

11. An electronic device comprising a display panel, wherein the display panel comprises a pixel layer comprising:

a first display region, a plurality of first pixel units being disposed in the first display region; and a second display region, a plurality of second pixel units being disposed in the second display region, wherein a first light-emitting ratio of the first display region is equal to a second light-emitting ratio of the second display region, the first light-emitting ratio being a ratio of an area of first pixel units in a unit area of the first display region to the unit area of the first display region, and the second light-emitting ratio being a ratio of an area of second pixel units in a unit area of the second display region to the unit area of the second display region; for a first pixel unit and a second pixel unit of a same color, the second pixel unit has an area smaller than or equal to the first pixel unit; and light from a display side of the display panel can pass through the second display region to reach a back side of the display panel.

12. The electronic device of claim 11, further comprising: a camera module disposed on a back of the display panel, a projection region of the camera module on the display panel being in the second display region.

13. The electronic device of claim 11, wherein for the first pixel unit and the second pixel unit of a same color, the second pixel units has an area smaller than the first pixel unit.

14. The electronic device of claim 11, wherein the second display region comprises:

a light-transmitting display region having a light-transmitting region that allows light from the display side of the display panel to pass through the display panel; and a transition display region between the first display region and the light-transmitting display region, wherein the display panel further comprises: a driving circuit layer comprising a plurality of pixel driving units, light-transmitting driving units being disposed in a projection region of the transition display region on the driving circuit layer, and the light-transmitting driving units are pixel driving units connected with second pixel units in the light-transmitting display region.

15. The electronic device of claim 14, wherein one light-transmitting driving unit is electrically connected with more than one second pixel unit.

16. The electronic device of claim 15, wherein the pixel layer comprises a plurality of pixel electrodes, pixel electrodes of the more than one second pixel unit connected with the one light-transmitting driving unit are connected with one another through a first connection trace, and the pixel electrodes of the more than one second pixel unit are connected with the one light-transmitting driving unit through a via, the first connection trace being disposed in the pixel layer.

17. The electronic device of claim 15, wherein the pixel layer comprises a plurality of pixel electrodes, and a pixel electrode of each of the more than one second pixel unit is connected with the light-transmitting driving unit through a via.

18. The electronic device of claim 14, wherein transition driving units are disposed in the projection region of the transition display region on the driving circuit layer, the transition driving units being pixel driving units, among the plurality of pixel driving units, connected with second pixel units in the transition display region.

19. The electronic device of claim 18, wherein one transition driving unit is connected with more than one second pixel unit.

20. The electronic device of claim 11, wherein the second display region comprises a plurality of repeating pixel regions, and each pixel region comprises two rows of second pixel units, wherein a second pixel unit of red, a second pixel unit of green, a second pixel unit of blue, a second pixel unit of green, a second pixel unit of blue and a second pixel unit of green are sequentially distributed in a first row of second pixel units; and a second pixel unit of green, a second pixel unit of blue, a second pixel unit of green, a second pixel unit of blue, a second pixel unit of green, a second pixel unit of red, a second pixel unit of green, and a second pixel unit of red are sequentially distributed in a second row of second pixel units.

FIG. 1

FIG. 2

FIG. 3

FIG. 4

FIG. 5

FIG. 6

FIG. 7

## INTERNATIONAL SEARCH REPORT

| International application No. |
|---|
| **PCT/CN2021/092084** |

**A.    CLASSIFICATION OF SUBJECT MATTER**

G02F 1/1333(2006.01)i;   G02F 1/133(2006.01)i;   G02F 1/1345(2006.01)i;   G03B 29/00(2021.01)i

According to International Patent Classification (IPC) or to both national classification and IPC

**B.    FIELDS SEARCHED**

Minimum documentation searched (classification system followed by classification symbols)

G02F G03B H01L

Documentation searched other than minimum documentation to the extent that such documents are included in the fields searched

Electronic data base consulted during the international search (name of data base and, where practicable, search terms used)

CNABS; CNTXT; VEN; USTXT; WOTXT; EPTXT; CNKI: 全, 屏, 摄像, 相机, 像素, 象素, 画素, 尺寸, 面积, 发光比, 透光, camera?, CCD, pixel?, area, size, full, screen

**C.    DOCUMENTS CONSIDERED TO BE RELEVANT**

| Category* | Citation of document, with indication, where appropriate, of the relevant passages | Relevant to claim No. |
|---|---|---|
| PX | CN 111708195 A (GUANGDONG OPPO MOBILE TELECOMMUNICATIONS CORP., LTD.) 25 September 2020 (2020-09-25)<br>    description, paragraphs [0024]-[0076], and figures 1-7 | 1-20 |
| X | CN 110492018 A (WUHAN CHINA STAR OPTOELECTRONICS SEMICONDUCTOR DISPLAY TECHNOLOGY CO., LTD.) 22 November 2019 (2019-11-22)<br>    description, paragraphs [0036]-[0108], and figures 1-16 | 1-20 |
| X | CN 110456571 A (OPPO (CHONGQING) INTELLIGENT TECHNOLOGY CO., LTD.) 15 November 2019 (2019-11-15)<br>    description, paragraphs [0027]-[0063], and figures 1-7 | 1, 2, 10-13, 20 |
| A | CN 108717244 A (BOE TECHNOLOGY GROUP CO., LTD. et al.) 30 October 2018 (2018-10-30)<br>    entire document | 1-20 |
| A | JP 2017092084 A (CANON K. K.) 25 May 2017 (2017-05-25)<br>    entire document | 1-20 |

☐ Further documents are listed in the continuation of Box C.          ☑ See patent family annex.

| | | |
|---|---|---|
| * | Special categories of cited documents: | |
| "A" | document defining the general state of the art which is not considered to be of particular relevance | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T"  later document published after the international filing date or priority date and not in conflict with the application but cited to understand the principle or theory underlying the invention

"X"  document of particular relevance; the claimed invention cannot be considered novel or cannot be considered to involve an inventive step when the document is taken alone

"Y"  document of particular relevance; the claimed invention cannot be considered to involve an inventive step when the document is combined with one or more other such documents, such combination being obvious to a person skilled in the art

"&"  document member of the same patent family

| Date of the actual completion of the international search | Date of mailing of the international search report |
|---|---|
| **02 July 2021** | **16 July 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/092084**

| Patent document cited in search report | | | Publication date (day/month/year) | Patent family member(s) | | | Publication date (day/month/year) |
|---|---|---|---|---|---|---|---|
| CN | 111708195 | A | 25 September 2020 | | None | | |
| CN | 110492018 | A | 22 November 2019 | WO | 2021027106 | A1 | 18 February 2021 |
| | | | | CN | 210429886 | U | 28 April 2020 |
| | | | | US | 2021043702 | A1 | 11 February 2021 |
| CN | 110456571 | A | 15 November 2019 | | None | | |
| CN | 108717244 | A | 30 October 2018 | WO | 2019218731 | A1 | 21 November 2019 |
| | | | | US | 20200211480 | A1 | 02 July 2020 |
| JP | 2017092084 | A | 25 May 2017 | | None | | |

Form PCT/ISA/210 (patent family annex) (January 2015)

**EP 4 145 214 A1**

**REFERENCES CITED IN THE DESCRIPTION**

**Patent documents cited in the description**

- CN 202010485478